Europäisches Patentamt

(19) European Patent Office

Office européen des brevets

(11) Publication number: **0 108 314**
A2

## (12) EUROPEAN PATENT APPLICATION

(21) Application number: **83110541.6**

(22) Date of filing: **21.10.83**

(51) Int. Cl.³: **H 01 L 27/01**

(30) Priority: **03.11.82 US 438918**

(43) Date of publication of application:
**16.05.84 Bulletin 84/20**

(84) Designated Contracting States:
**AT BE CH DE FR GB IT LI LU NL SE**

(71) Applicant: RADIANT TECHNOLOGY CORPORATION
13856 Bettencourt Street
Cerritos California 90701(US)

(72) Inventor: Flattery, David Kevin
1860-F West Glenoaks
Anaheim California 92801(US)

(74) Representative: Patentanwälte Grünecker, Dr.
Kinkeldey, Dr. Stockmair, Dr. Schumann, Jakob, Dr.
Bezold, Meister, Hilgers, Dr. Meyer-Plath
Maximilianstrasse 58
D-8000 München 22(DE)

(54) Method for manufacturing multi-layered, thick film circuits.

(57) A plurality of layers of a multi-layered, thick film circuit are simultaneously fired in an infrared furnace after being separately applied to the underlying substrate and separately dried. Specifically, a first layer of a hardenable conductive paste containing conductive particles in a volatile organic binder is applied to a substrate. Then, the first layer is dried at low temperature to remove most of the volatiles, without fusing the particles. Next, a second layer of a hardenable dielectric paste containing dielectric particles in a volatile organic binder is applied to the first layer. Then, the second layer is dried at low temperature to remove most of the volatiles, without fusing the particles. This process is repeated until a desired number of layers has been formed on the thick film circuit. The final step is to fire all the layers simultaneously in an infrared furnace at high temperature to fuse the particles of each layer.

_Fig.2_

PRINT → DRY → PRINT → DRY → ⋯ → PRINT → DRY → FIRE

EP 0 108 314 A2

14895/LTR-sgd            -1-

## METHOD FOR MANUFACTURING MULTI-LAYERED, THICK FILM CIRCUITS

### Background of the Invention

This invention relates to electronic components and, more particularly, to a method for manufacturing multi-layered, thick film circuits.

In recent years, thick film circuits have become widely used electrical components. Many thick film circuits have a plurality of conductive layers separated by dielectric layers and supported on an insulative substrate. The conductive and dielectric layers are applied to the substrate in paste form by silk screen printing techniques, which permit high resolution in the patterns formed in each layer and small uniform thickness. After each layer is printed on the substrate, such layer is first dried and then fired preparatory to the printing of the next layer. Typically, the printing time is about a minute or less, the drying time is about 10 to 15 minutes and the firing time in a conventional furnace is about 60 minutes. As used herein, the term

14895/LTR                    -2-

"conventional furnace" refers to a furnace in which the thick film circuits are fired by convection and radiation from the interior furnace walls or muffle, which typically is concentrated in a wavelength band of 2.5 to 20 microns. The time required to manufacture an entire thick film circuit is more than an hour times the number of layers. Attempts have been made to fire more than one layer at a time in a conventional furnace without success, because the top conductive layer is then not solderable, the layers tend to diffuse, which changes the designed dielectric constant and breakdown voltage, and the layers are subject to damage due to the escape of volatiles from the paste.

As described in copending application Serial No. 306,200, filed September 28, 1981, it is known to fire thick film circuits in an infrared furnace one layer at a time. As used herein, the term "infrared furnace" means a furnace in which the thick film circuits directly exposed to energy from an infrared source, typically concentrated in a wavelength band of .5 to 2.5 microns. It has been found that such direct infrared radiation selectively heats the layer being fired without appreciably heating the substrate, because the substrate has a large mass and low infrared absorptivity and the layer being fired has a small mass and a high infrared absorptivity.

## Summary of the Invention

According to the invention, a plurality of layers of a multi-layered, thick film circuit are simultaneously fired in an infrared furnace after being separately applied

0108314

14895/LTR                 -3-

to the underlying substrate and separately dried.  It has been found that direct infrared radiation permits multiple layers to be fired simultaneously without causing the problems described above.  Specifically, a first layer of a hardenable, conductive paste containing conductive particles in a volatile organic binder is applied to a substrate.  Then, the first layer is dried at low temperature to remove most of the volatiles, without fusing the particles.  Next, a second layer of a hardenable, dielectric paste containing dielectric particles in a volatile organic binder is applied to the first layer.  Then, the second layer is dried at low temperature to remove most of the volatiles, without fusing the particles.  From two to four dielectric layers are applied in this manner.  This process is repeated until a desired number of layers has been formed on the thick film circuit.  The final step is to fire all the layers simultaneously in an infrared furnace at high temperature to fuse the particles of each layer without appreciable diffusion of particles between layers, substrate warpage, or damage to the layers.

Brief Description of the Drawings

The features of a specific embodiment of the best mode contemplated of carrying out the invention are illustrated in the drawings, in which:

FIG. 1 is a block diagram of a prior art method for manufacturing thick film circuits;

FIG. 2 is a block diagram of a method for manufacturing thick film circuits in accordance with the principles of the invention;

FIG. 3 is a diagram of a typical multi-layered, thick film circuit; and

FIG. 4 is a schematic block diagram of an infrared furnace used in practicing the invention.

## Detailed Description of the Specific Embodiment

Conventionally, a thick film circuit is manufactured by applying layers of commercially available conductive paste and dielectric paste to an insulative substrate, typically a ceramic material such as 96 percent alumina by screen printing. The paste contains fusable conductive or dielectric particles in an organic binder and has an ink consistency suitable for application by a screening process.

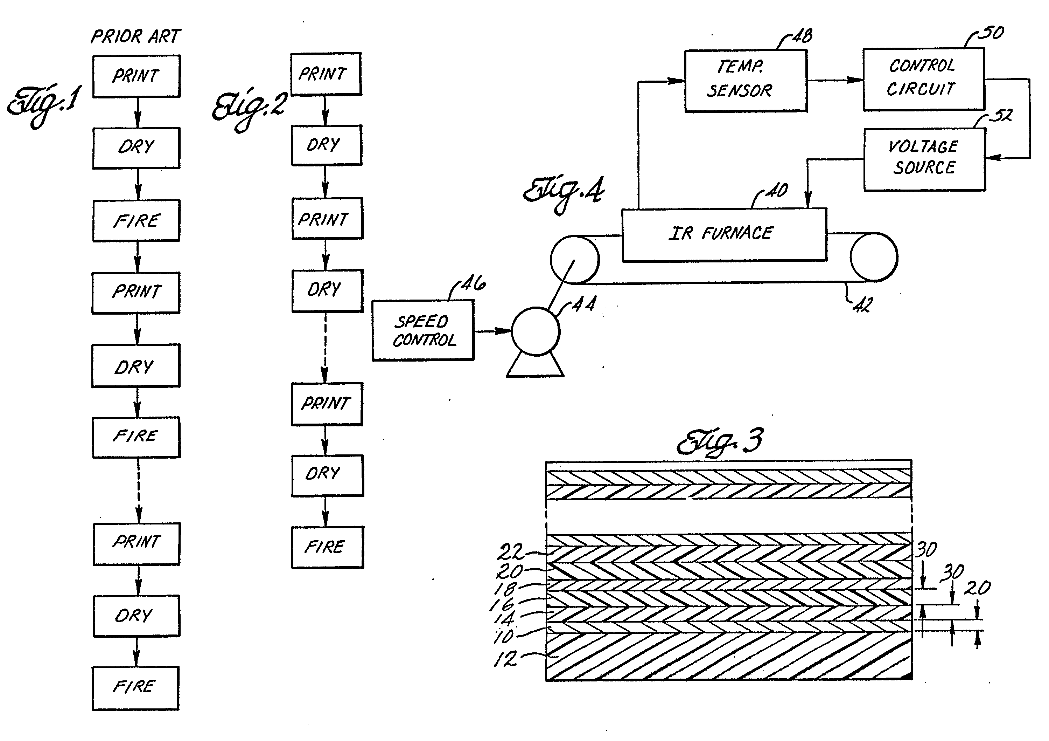

A typical multi-layered, thick film circuit is illustrated in FIG. 3. A conductive layer 10 covers the surface of a dielectric substrate 12. A dielectric layer 14 covers layer 10. Another dielectric layer 16 covers dielectric layer 14. A conductive layer 18 covers dielectric layer 16. A dielectric layer 20 covers conductive layer 18. Another dielectric layer 22 covers dielectric layer 20; and so on and so forth to form the desired number of layers. Typically, two dielectric layers are interposed between each pair of conductive layers, the dried conductive layers are of the order of 20 microns thick and each dried dielectric layer is of the order of 30 to 40 microns thick. Typically, the conductor could be silver or other precious metal or copper or other base metal and the dielectric could be a mixture of glasses and ceramics, often based on a lead borosilicate material, such as DuPont 9950 or 4575D thick film dielectric composition.

As illustrated by FIG. 1, the prior art method for manufacturing a thick film circuit of the type shown in FIG. 3, is to print, dry, and fire each conductive and dielectric layer separately. Typically, the drying step heats the thick film circuit to a temperature between 125° and 175°C for about 15 minutes to remove most of the

14895/LTR                    -6-

volatiles without fusing the particles; the layer is dried enough not to be tacky or wet to the touch, and is provided dimensional stability by the setting of the organic binder.  Most commonly, each firing step is carried out in a conventional furnace in which the thick film circuit is heated by convection and indirect radiation from the interior furnace or muffle walls to a temperature between 850° and 950°C  The processing time for each layer is approximately 60 minutes.  A recent innovation is a single-layer firing in an infrared furnace in which energy from an infrared source is directly radiated to a thick film circuit.  The processing time in an infrared furnace is reduced to as little as five minutes.

As illuatrated in FIG. 2, the invention fires all the layers of a thick film circuit simultaneously after each layer is separately printed and dried.  It has been discovered that none of the shortcomings of multiple-layer firing in a conventional furnace occur and the processing time is substantially reduced because only one firing operation is required.  When the infrared furnace is properly operated, the resulting thick film circuit is free of surface demormities due to rapid release of volatiles, exhibits a controlled dielectric constant, and has a solderable top conductive layer.  Further, the substrate does not warp.  Up to four conductive layers with intermediate dielectric layers having a total thickness of about 300 microns have been simultaneously fired in an infrared furnace utilizing the invention without adverse results.  The total approximate firing time is 8.3 minutes.

14895/LTR                    -7-

Preferably, thick film circuits are fired in accordance with the invention in the infrared furnace disclosed in application Serial No. 306,200, filed September 28, 1981, or application Serial No. 381,901, filed May 25, 1982. The disclosures of these applications are incorporated fully herein by reference. A typical infrared furnace for carrying out the described simultaneous firing is shown in FIG. 4. Thick film circuits to be fired are transported through an infrared (IR) furnace 40 by a conveyor 42. Conveyor 42 is driven by a motor 44 having a speed control 46. A temperature sensor 48 monitors the temperature in the firing chamber of furnace 40. Responsive to temperature sensor 48, a control circuit 50 adjusts the magnitude of the voltage applied to the infrared lamps in furnace 40 by a voltage source 52. Separate control loops identical to temperature sensor 48, control circuit 50, and voltage source 52 could be provided if desired for different zones in the firing chamber of furnace 40 so as to establish the desired temperature profile for the thick film circuits on conveyor 42. In any case, the control loop increases and decreases the energy radiated by the infrared lamps so as to maintain a constant temperature within the firing chamber or zone thereof, as the case may be. As the transport speed of conveyor 42 increases responsive to speed control 46, more infrared energy is delivered to each thick film circuit because more energy must be radiated by the infrared lamps to maintain a constant temperature. Typically, the infrared energy is concentrated in a wavelength band of 0.5 to 2.5 microns. The peak bulk furnace temperature is typically between 850° and 950°C. Speed control 46 is adjusted until the energy absorbed by the thick film circuits is sufficient to fire the thickness of the multi-layered material to completion without the described adverse effects.

14895/LTR                    -8-

WHAT IS CLAIMED IS:

   1.   A method for manufacturing thick film circuits comprising the following steps in the order recited:
      printing on a substrate a first thin layer of a hardenable conductive paste containing fusable conductive particles in a volatile binder;
      drying the first layer;
      applying on the first layer a second thin layer of hardenable dielectric paste containing fusable dielectric particles in a volatile binder;
      drying the second layer;
      applying to the second layer a third thin layer of hardenable conductive paste containing fusable conductive particles in a volatile binder;
      drying the third layer; and
      firing the substrate including the first, second, and third layers to fuse the particles of the respective layers to each other and to release the remaining volatile binder.

## Fig.1

PRIOR ART

PRINT → DRY → FIRE → PRINT → DRY → FIRE ⇢ PRINT → DRY → FIRE

## Fig.2

PRINT → DRY → PRINT → DRY ⇢ PRINT → DRY → FIRE

## Fig.4

TEMP. SENSOR *48* → CONTROL CIRCUIT *50*

VOLTAGE SOURCE *52*

IR FURNACE *40*

*42*

SPEED CONTROL *46* → *44*

## Fig.3

22, 20, 18, 16, 14, 10, 12

30, 30, 20